# EUROPEAN PATENT APPLICATION

(11) **EP 2 398 063 A1**
(43) Date of publication of application: **21.12.2011**
(21) Application number: 09840013.8
(22) Date of filing: 16.02.2009
(51) Int. Cl.: H01L 31/042

(54) **SOLAR BATTERY MODULE**

(71) Applicant: Mitsubishi Electric Corporation, Tokyo 100-8310 (JP)
(72) Inventor: ISHIHARA, Takashi, Tokyo 100-8310 (JP); MORIKAWA, Hiroaki, Tokyo 100-8310 (JP)
(74) Representative: Pfenning, Meinig & Partner GbR
(86) International application number: PCT/JP2009/052564
(87) International publication number: WO 2010/092693

(57) **Abstract**

A solar battery module having a plurality of solar battery cells embedded in an in-plane direction in a front-surface sealing member by separating the solar battery cells at a distance therebetween, the solar battery cells being electrically connected to each other in a filling material sandwiched between the front-surface sealing member having translucency and a back-surface sealing member. The back-surface sealing member is a high reflectance portion having a high reflection rate such that an average reflection rate of light of a wavelength in a range of 400 to 1200 nanometers is equal to or higher than 50% in at least a region corresponding to the solar battery cells, and the back-surface sealing member includes a low reflectance portion having a low reflection rate such that an average reflection rate of light of a wavelength in a range of 400 to 1200 nanometers is lower than 50%, at any position between a front surface of the reflection prevention film of the solar battery cells and the back-surface sealing member, in a region between the solar battery cells adjacent to each other or in a region corresponding to a region in a thickness direction of the solar battery module.

## Description

### TECHNICAL FIELD

The present invention relates to a solar battery module.

### BACKGROUND ART

To improve the performance of a photovoltaic device such as a solar battery, effective utilization of light that is incident to the photovoltaic device is important. Particularly, in a crystalline solar battery, light that reaches a back surface of the crystalline solar battery increases more than conventional techniques, with advance in thinning of a solar battery substrate aiming at cost reduction. Therefore, the performance of the crystalline solar battery can be improved by effectively using the light that reaches the back surface of the crystalline solar battery.

A general crystalline solar battery having electrodes formed on the entire back surface of a solar battery substrate is used as a solar battery module (hereinafter, "module") that has a plurality of crystalline solar battery cells (hereinafter, "cells") formed as a package by separating the cells with a predetermined distance therebetween in an in-plane direction of a module glass as a front-surface sealing member in a filling material sandwiched between the module glass and a back sheet as a back-surface sealing member. By using for the back sheet, a high-reflectance back sheet of a white color or the like having a high light-reflection characteristic, light having reached the back sheet is efficiently reflected and inputted again into the cells, thereby effectively using the light. That is, reflection light from the high-reflectance back sheet that is exposed in a region between adjacent cells is reflected again by the module glass and inputted again into the cells, thereby increasing a photogenerated current and making it possible to increase power generated by the module (see, for example, Patent Document 1).

However, when the high-reflectance back sheet is used, there is also an increase of light that is reflected from the high-reflectance back sheet exposed between the cells and that passes between the cells to be emitted to outside. Therefore, strong light is reflected to a specific direction determined by an installation angle and an installation height of the module and the orbit of the sun, and unnecessary light pollution is generated at a position of receiving the reflection light.

When a low-reflectance back sheet having a low light-reflection characteristic is used, the light pollution can be suppressed. For example, a back sheet of a low reflectance color other than white, such as black and blue, can be used. Because reflection light from the low-reflectance back sheet is smaller than reflection light when a high-reflectance back sheet is used, reflection light that passes between the cells and is emitted to outside becomes small and light pollution can be suppressed. However, light that is reflected from the low-reflectance back sheet and the module glass and is inputted again into the cells also becomes small. Accordingly, when the low-reflectance back sheet is used, an output of the solar battery module becomes smaller than that when the high-reflectance back sheet is used.

Patent Document 1: Japanese Patent Application Laid-open No. 2002-100788

### DISCLOSURE OF INVENTION

### PROBLEM TO BE SOLVED BY THE INVENTION

In a general crystalline solar battery such as that described above, because back surface electrodes are formed on the entire back surface of a solar battery substrate, when thinning of the solar battery substrate is progressed, warpage occurs in the crystalline solar battery due to stress generated because of a difference between a thermal expansion coefficient of the material of the solar battery substrate and a thermal expansion coefficient of the material of the back surface electrode. This warpage becomes a cause of generating breaking and cracks of the crystalline solar battery in subsequent assembly processes, and this warpage becomes a serious problem. Particularly, this warpage becomes a serious problem in a crystalline-silicon solar battery having an issue of thinning a solar battery to suppress material consumptions.

Accordingly, there is progressed development of a method for reducing stress generated due to the difference between thermal expansion coefficients described above, by forming back surface electrodes on a part of a surface of the solar battery substrate without forming the electrodes on the entire surface of the substrate. For example, there is proposed a solar battery (hereinafter, "back-surface passivation solar battery") that is configured to suppress carrier recoupling on a back surface of a crystalline solar battery, by covering with a passivation film a region other than a formation portions of back surface electrodes on the back surface of the solar battery substrate. As for the passivation film, a film that can suppress an interface state to crystalline silicon at a low level is used, such as a silicon oxide film (SiOx), a silicon nitride film (SiN), and a silicon oxynitride film (SiON). Because these films are basically transparent dielectric films, light having reached the back surface of the solar battery substrate is transmitted to outside through the passivation film.

Further, the back-surface passivation solar battery is also used as a module that has a plurality of cells formed as a package by separating the cells at a predetermined distance therebetween in an in-plane direction of a module glass in a filling material sandwiched between the module glass and the back sheet, in a similar manner to that of the crystalline solar battery having electrodes formed on the entire back surface. By using a high-reflectance back sheet having a white color or the like that has a high light-reflection characteristic for the back sheet, light can be effectively used by efficiently reflecting the light having reached the back sheet and by inputting the light again into the cells. That is, reflection light from the high-reflectance back sheet that is exposed to a region between adjacent cells is reflected again by the module glass and is inputted again into the cells, thereby increasing the photogenerated current and making it possible to increase the power generated by the module.

In this case, in the back-surface passivation solar battery, because the light having reached the back surface of the solar battery substrate is transmitted to outside through the passivation film, more reflection light by the back sheet can be obtained than light obtained by the general crystalline solar battery, and therefore the current generated by the cells can be increased. Further, because recoupling of carriers can be suppressed by reducing an interface state between the solar battery substrate and the passivation film, the voltage generated by the cells is also increased.

However, in the back-surface passivation solar battery, because a substantial increase of a generated current is expected by light reflected from the back sheet just below the back surface of the cells that occupy the most area of the module, not in the region between the cells, use of a low-reflectance back sheet on the entire surface as the back sheet has a crucial problem of reducing an output, and thus it is not possible to achieve a large output.

Meanwhile, when a high-reflectance back sheet is used, there is a problem in generating light pollution because reflection light on the back surface of the module is emitted to outside by passing between the cells, in a similar manner to that of the module that uses general cells on the entire back surface of which electrodes are formed.

As a result, in a back-surface passivation solar battery module, it is difficult to achieve both a high output and suppression of light pollution.

The present invention has been achieved in view of the above problems, and an object of the present invention is to provide a solar battery module that can achieve both a high output and suppression of light pollution while thinning a solar battery substrate.

### MEANS FOR SOLVING PROBLEM

In order to solve the above problem and in order to attain the above object, a solar battery module of the present invention includes a plurality of solar battery cells embedded in an in-plane direction in a front-surface sealing member by separating the solar battery cells at a distance therebetween. Here, the solar battery cells are electrically connected to each other in a filling material sandwiched between the front-surface sealing member having translucency and a back-surface sealing member. Additionally, each of the solar battery cells includes: a first-conductivity-type semiconductor substrate that has an impurity diffusion layer having a second-conductivity-type impurity element diffused thereon at one surface side; a reflection prevention film that is formed on the impurity diffusion layer; a first electrode that is electrically connected to the impurity diffusion layer by penetrating the reflection prevention film; a passivation film that is formed at another surface side of the semiconductor substrate; and a second electrode that is embedded in the passivation film and is electrically connected to the another surface side of the semiconductor substrate. More additionally, the back-surface sealing member is a high reflectance portion having a high reflection rate such that an average reflection rate of light of a wavelength in a range of 400 to 1200 nanometers is equal to or higher than 50% in at least a region corresponding to the solar battery cells, and the back-surface sealing member includes a low reflectance portion having a low reflection rate such that an average reflection rate of light of a wavelength in a range of 400 to 1200 nanometers is lower than 50%, at any position between a front surface of the reflection prevention film of the solar battery cells and the back-surface sealing member, in a region between the solar battery cells adjacent to each other or in a region corresponding to a region in a thickness direction of the solar battery module.

### EFFECT OF THE INVENTION

According to the present invention, a solar battery module that can achieve both a high output and suppression of light pollution while thinning a solar battery substrate can be provided.

### BRIEF DESCRIPTION OF DRAWINGS

[FIG. 1] FIG. 1 is a cross-sectional view of a configuration of a solar battery module according to a first embodiment of the present invention.
[FIG. 2] FIG. 2 is a cross-sectional view of a configuration of a solar battery cell according to the first embodiment.
[FIG. 3] FIG. 3 is a cross-sectional view of a configuration of a conventional solar battery module in which a back-surface sealing member is made of only a high-reflectance back sheet.
[FIG. 4] FIG. 4 is a cross-sectional view of a configuration of a conventional solar battery module in which a back-surface sealing member is made of only a low-reflectance back sheet.
[FIG. 5] FIG. 5 is a cross-sectional view of a configuration of a solar battery module according to a second embodiment of the present invention.
[FIG. 6] FIG. 6 is a cross-sectional view of a configuration of a solar battery module according to a third embodiment of the present invention.

### EXPLANATIONS OF LETTERS OR NUMERALS

- 1: back-surface passivation solar battery cell (cell)
- 2: semiconductor substrate
- 3: impurity diffusion layer
- 4: reflection prevention film
- 5: front surface electrode
- 6: back surface electrode
- 7: passivation film
- 10: solar battery module (module)
- 21: front-surface sealing member (module glass)
- 22: filling material (sealant)
- 22a: front-surface filling material (sealant)
- 22b: back-surface filling material (sealant)
- 23: high-reflectance back sheet
- 24: low-reflectance back sheet
- 31: incident light
- 32: reflection light
- 32a: reflection light
- 33: reflection light
- 34: reflection light
- 35: incident light
- 36: reflection light
- 36a: reflection light
- 36b: reflection light
- 37: reflection light
- 38: reflection light
- 40: solar battery module (module)
- 41: low reflectance sheet
- 41: low reflectance portion
- 50: solar battery module (module)
- 51: low reflectance sheet

### BEST MODE(S) FOR CARRYING OUT THE INVENTION

Exemplary embodiments of a solar battery module according to the present invention will be explained below in detail with reference to the accompanying drawings. The present invention is not limited to following descriptions but can be appropriately changed without departing from the scope of the present invention. In the drawings explained below, to facilitate understanding, respective scales of members are sometimes different from actual products. The same holds true for respective scales of the drawings.

### First embodiment.

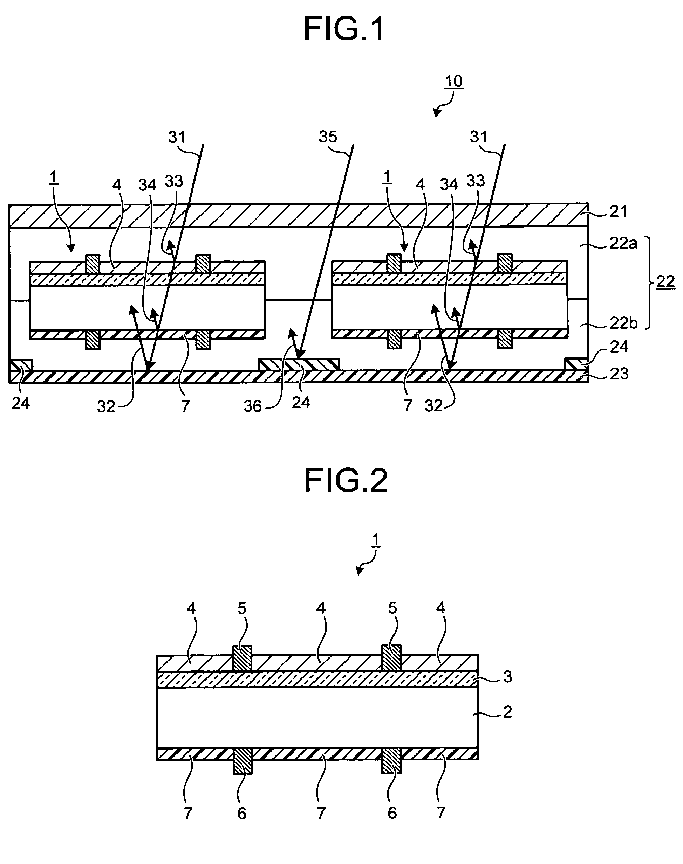

FIG. 1 is a cross-sectional view of a configuration of a solar battery module according to a first embodiment of the present invention. A solar battery module 10 (hereinafter, "module 10") according to the present embodiment has a configuration (not shown) such that a plurality of back-surface passivation solar battery cells 1 (hereinafter, "cells 1") are electrically connected to each other. FIG. 2 is a cross-sectional view of a configuration of the cell 1 according to the first embodiment.

First, the configuration of the cell 1 is explained with reference to FIG. 2. In the cell 1 according to the present embodiment, an n-type impurity diffusion layer 3 is formed by phosphorus diffusion and a reflection prevention film 4 made of a silicon nitride film is also formed, at a light-reception surface side of a semiconductor substrate 2 that is made of P-type polycrystalline silicon. For the semiconductor substrate 2 as a solar battery substrate, a P-type monocrystalline or polycrystalline silicon substrate can be used. The semiconductor substrate 2 is not limited thereto, and an n-type silicon substrate can be also used for the semiconductor substrate 2. Fine unevenness is formed as a texture structure on a front surface at the light-reception surface side of the semiconductor substrate 2 of the cell 1. The fine unevenness is configured to increase an area of absorbing light from outside on the light reception surface, suppress reflectance on the light reception surface, and confine the light.

At the light-reception surface side of the semiconductor substrate 2, front surface electrodes 5 that are electrically connected to the impurity diffusion layer 3 are provided. For the front surface electrodes 5, grid electrodes and bus electrodes are provided. A plurality of long slender grid electrodes are arranged at the light-reception surface side of the semiconductor substrate 2. Bus electrodes that are conductive to the grid electrodes are provided so as to be approximately orthogonal with the grid electrodes. Both the grid electrodes and the bus electrodes are electrically connected to the impurity diffusion layer 3 at bottom surface portions, respectively. The grid electrodes and the bus electrodes are configured by a silver material. On the other hand, back surface electrodes 6 made of an aluminum material are provided on a part of a back surface (a surface at the opposite side of the light reception surface) of the semiconductor substrate 2, in a similar manner to that of the front surface electrodes 5 (bus electrodes). Regions in which the back surface electrodes 6 are not formed on the back surface of the semiconductor substrate 2 are covered by passivation films 7 having translucency.

A configuration of the module 10 is explained next with reference to FIG. 1. The module 10 has a plurality of the cells 1 formed as a package by separating the cells at a predetermined distance therebetween in an in-plane direction of a module glass 21, in a filling material (sealant) 22 sandwiched between a front-surface sealing member 21 that is arranged at a front surface side of the module 10 and a high-reflectance back sheet 23 as a back-surface sealing member that is arranged at a back surface side of the module 10. The cells 1 adjacent to each other are electrically connected to each other.

The front-surface sealing member 21 is made of a material having translucency, and a module glass, for example, is used for the front-surface sealing member 21 (hereinafter, "module glass 21"). The filling material (sealant) 22 consists of a front-surface filling material (sealant) 22a that seals a front surface side of the cell 1, and a back-surface filling material (sealant) 22b that seals a back surface side of the cell 1. An EVA (ethylene vinyl acetate) resin, for example, is used for the front-surface filling material (sealant) 22a and the back-surface filling material (sealant) 22b. The cell 1 is sandwiched by these two EVA resins.

The high-reflectance back sheet 23 has a metallic color such silver or white, and is a high reflectance unit having a high reflection rate of light. A low-reflectance back sheet 24 as a low reflectance unit having a low reflection rate of light is provided in a region corresponding to a region between adjacent cells 1 and in a region of an external peripheral portion of the module 10. The high reflection rate means that an average reflection rate of light of a wavelength in a range of 400 to 1200 nanometers is equal to or higher than 50%. The low reflection rate means that an average reflection rate of light of a wavelength in a range of 400 to 1200 nanometers is lower than 50%. A dark color means a color having a low reflection rate of light.

In the present embodiment, the high-reflectance back sheet 23 is a high-reflectance back sheet that has both a high reflection rate and an insulation property formed by adding a white pigment to an insulation resin or the like. A high-reflectance back sheet that has both a high reflection rate and an insulation property can be also configured by covering a metal foil with an insulation resin or the like.

In the present embodiment, the low-reflectance back sheet 24 is a coated portion that is formed by coating in a dark color a region at the module glass 21 side of the high-reflectance back sheet 23 and corresponding to a region between adjacent cells 1 and a region of an external peripheral portion of the module 10. The low-reflectance back sheet 24 can be also formed by partially adding a dark color pigment at a predetermined position of the high-reflectance back sheet 23. Further, a low-reflectance material portion, for example, a low-reflectance back sheet, can be stacked at a predetermined position on the high-reflectance back sheet 23.

In FIG. 1, although the module 10 that is packaged by including two cells 1 is shown, the number of the cells 1 is not limited thereto, and the module 10 can be also configured to include many cells 1.

In the module 10 configured as described above, incident light 31 of sunlight that is directly inputted to the cells 1 is reflected by the high-reflectance back sheet 23 after having transmitted through the cells 1, and becomes reflection light 32, and is inputted again into the cells 1. A part of the incident light 31 is reflected by the front surface of the reflection prevention film 4, and becomes reflection light 33. The reflection light 33 is divided into light (not shown) that is further reflected by the module glass 21 and is inputted again into the cells 1, and light (not shown) that directly exits to outside by passing through the module glass 21. Further, a part of the incident light 31 is reflected by front surfaces of the passivation films 7 and becomes reflection light 34, and is inputted again into the cells 1.

Further, most of incident light 35 of sunlight that is directly inputted between adjacent cells 1 is absorbed by the low-reflectance back sheet 24, and reflection light 36 becomes small. Accordingly, the reflection light 36 that is emitted to outside by passing between the cells 1 becomes small, and unnecessary light pollution to outside can be suppressed.

Meanwhile, light that is reflected by the low-reflectance back sheet 24 and is further reflected by the module glass 21 and is inputted again into the cells 1 becomes small. However, in the cells 1, light having reached the back surface of the semiconductor substrate 2 is transmitted to outside through the passivation films 7. A generated current can be substantially increased by the reflection light 32 by the high-reflectance back sheet 23 just below the back surface of the cells 1 that occupy the most area of the module 10. Because recoupling of carriers can be suppressed by reducing an interface state between the semiconductor substrate 2 and the passivation films 7, a generated voltage is also increased. Consequently, a high output can be obtained in the module 10.

In the module 10, by forming the back surface electrodes 6 on a part of a surface of the semiconductor substrate 2 without forming the back surface electrodes 6 on the entire surface of the semiconductor substrate 2, occurrence of warpage caused by a difference between a thermal expansion coefficient of the semiconductor substrate 2 and that of the back surface electrodes 6 can be suppressed.

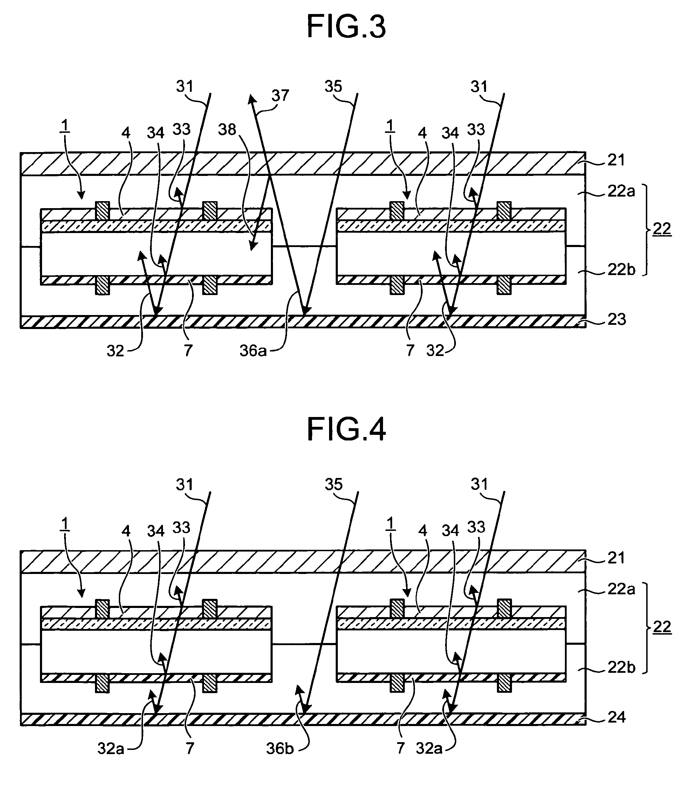

FIG. 3 is a cross-sectional view of a configuration of a conventional module in which a back-surface sealing member is made of only the high-reflectance back sheet 23 and in which the low-reflectance back sheet 24 as a low reflectance portion is not provided in a region corresponding to a region between adjacent cells 1 and in a region of an external peripheral portion of the module 10, on the front surface at the module glass 21 side. In this case, the incident light 35 of sunlight that is directly inputted between adjacent cells 1 is reflected by the high-reflectance back sheet 23, and becomes reflection light 36a. Because the reflection light 36a is reflection light of the high-reflectance back sheet 23, most of this light is not absorbed, and reflection light 37 that passes between the cells 1 and is emitted to outside increases, thereby generating unnecessary light pollution to outside. A part of the reflection light 36a is reflected by the front surface of the module glass 21 and becomes reflection light 38, and is inputted again into the cells 1.

FIG. 4 is a cross-sectional view of a configuration of a conventional module in which a back-surface sealing member is made of only the low-reflectance back sheet 24 and in which the high-reflectance back sheet 23 is not provided in a region corresponding to the back surface of the cells 1. In this case, most of the incident light 35 of sunlight that is directly inputted between adjacent cells 1 is absorbed by the low-reflectance back sheet 24, and the reflection light 36 becomes small. Accordingly, reflection light 36b that passes between the cells 1 and is emitted to outside decreases, thereby making it possible to suppress unnecessary light pollution to outside.

However, although the incident light 31 of sunlight that is directly inputted to the cells 1 is reflected by the low-reflectance back sheet 24 after having transmitted through the cells 1 and becomes reflection light 32a, most of the reflection light 32a is absorbed by the low-reflectance back sheet 24, and the reflection light 36 becomes small. Accordingly, the output is reduced, and a high output cannot be achieved.

A manufacturing method of the module 10 is explained next. First, a manufacturing method of the cells 1 is explained. The n-type impurity diffusion layer 3 is first formed by phosphorus diffusion at a light-reception surface side of a p-type polycrystalline silicon substrate as the semiconductor substrate 2. Next, the n-type impurity diffusion layer 3 formed on an end surface and a back surface is removed by etching, for example. Next, the reflection prevention film 4 is formed on the impurity diffusion layer 3. Thereafter, the front surface electrodes 5 are formed to be conductive to the n-type impurity diffusion layer 3. Various methods can be used to provide conduction. For example, the front surface electrodes 5 can be formed by fire-through that is generally used to form the front surface electrodes 5 in a mass production process of solar batteries.

Next, the passivation films 7 are formed at a back surface portion of the semiconductor substrate 2 to which p-type polycrystalline silicon is exposed. Thereafter, the back surface electrodes 6 are formed to be conductive to the p-type polycrystalline silicon. Various methods can be used to provide conduction. For example, the back surface electrodes 6 can be formed by fire-through that is generally used to form the front surface electrodes 5 in a mass production process of solar batteries. In addition to this method, the back surface electrodes 6 can be also formed by printing the back surface electrodes 6, after the passivation films 7 at portions where the back surface electrodes 6 are to be formed are removed by laser. Although the front surface electrodes 5 and the back surface electrodes 6 are formed by separate processes in this example, a process of higher productivity can be provided when the front surface and back surface electrodes are simultaneously formed by fire-through.

Next, a manufacturing method of the module 10 is explained. The front-surface filling material (sealant) 22a, a plurality of the cells 1 connected to each other to extract power to outside, the back-surface filling material (sealant) 22b, and the high-reflectance back sheet 23 are sequentially superimposed in this order on the module glass 21. Thereafter, these are thermally pressed in vacuum. As a result, portions from the module glass 21 to the high-reflectance back sheet 23 are integrated together by the front-surface filling material (sealant) 22a and the back-surface filling material (sealant) 22b, thereby completing the module 10.

In the high-reflectance back sheet 23, the low-reflectance back sheet 24 as a low reflectance portion is formed in advance in a region corresponding to a region between adjacent cells 1 and in a region of an external peripheral portion of the module 10. In this case, the low-reflectance back sheet 24 is formed by coating in a dark color a region at the module glass 21 side of the high-reflectance back sheet 23 and corresponding to a region between adjacent cells 1 and a region of an external peripheral portion of the module 10, and by drying these regions.

As described above, according to the module 10 of the present embodiment, light having transmitted through the cells 1 is reflected by the high-reflectance back sheet 23, and is inputted again into the cells 1, thereby making it possible to increase the output by increasing the current generated by the cells 1. At the same time, light inputted between adjacent cells 1 is reflected by the low-reflectance back sheet 24, thereby making it possible to suppress occurrence of unnecessary light reflection to outside of the module 10. In the module 10, by forming the back surface electrodes 6 on a part of a surface of the semiconductor substrate 2 without forming the back surface electrodes 6 on the entire surface of the semiconductor substrate 2, warpage caused by a difference between a thermal expansion coefficient of the semiconductor substrate 2 and that of the back surface electrodes 6 does not occur. Therefore, according to the module 10 of the present embodiment, a solar battery module that achieves a high output, thinning, and low light pollution can be obtained.

### Second embodiment.

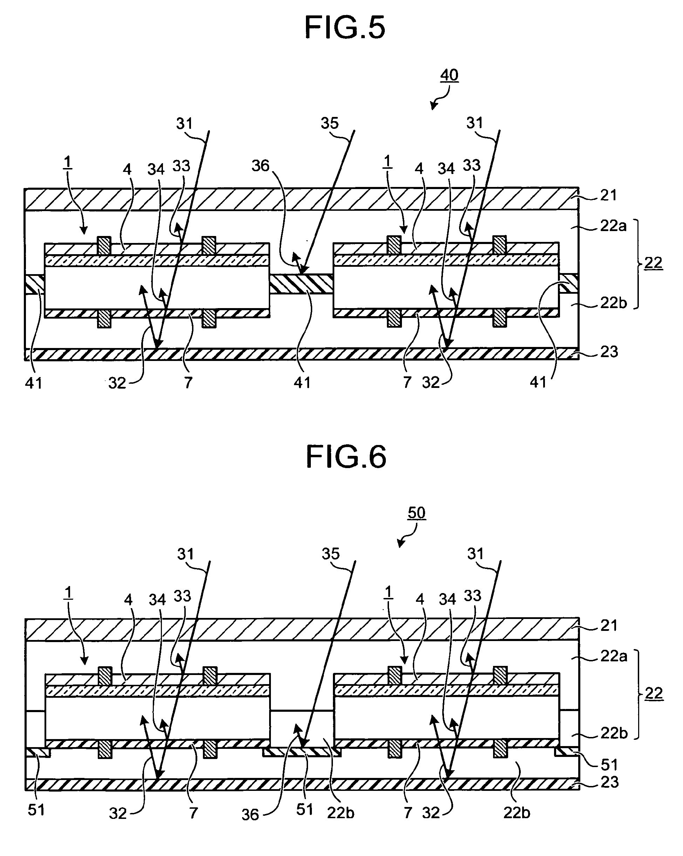

FIG. 5 is a cross-sectional view of a configuration of a module 40 according to a second embodiment of the present invention. The module 40 according to the present embodiment has a configuration (not shown) that a plurality of the cells 1 are electrically and directly connected to each other in a similar manner to that of the module 10. In FIG. 5, like reference letters or numerals are denoted to like members as those in FIG. 1 and detailed explanations thereof will be omitted.

The module 40 according to the second embodiment is different from the module 10 according to the first embodiment in that a low reflectance portion 41 having a low reflection rate is arranged between the front-surface filling material (sealant) 22a and the back-surface filling material (sealant) 22b, in a region between adjacent cells 1 and in an external peripheral region of the module 10. For the low reflectance sheet 41, a sheet having a dark color by mixing a pigment of a dark color into the filling material (sealant) 22 made of a transparent EVA resin, for example, can be used. Note that the low reflectance sheet 41 is not limited thereto, and is not limited to the EVA resin as far as the resin has a low reflection rate and can be arranged between adjacent cells 1.

In the module 40 configured as described above, the incident light 31 of sunlight that is directly inputted to the cells 1 is reflected by the high-reflectance back sheet 23 after having transmitted through the cells 1, and becomes the reflection light 32, and is inputted again into the cells 1. A part of the incident light 31 is reflected by the front surface of the reflection prevention film 4, and becomes the reflection light 33. The reflection light 33 is divided into light (not shown) that is further reflected by the module glass 21 and is inputted again into the cells 1, and light (not shown) that directly exits to outside by passing through the module glass 21. A part of the incident light 31 is reflected by the front surfaces of the passivation films 7 and becomes the reflection light 34, and is inputted again into the cells 1.

Further, most of the incident light 35 of sunlight that is directly inputted between adjacent cells 1 is absorbed by the low reflectance portion 41 that is arranged in a region between adjacent cells 1, and the reflection light 36 becomes small. Accordingly, the reflection light 36 that is emitted to outside by passing between the cells 1 becomes small, and unnecessary light pollution to outside can be suppressed.

Meanwhile, light that is reflected by the low reflectance portion 41 and is further reflected by the module glass 21 and is inputted again into the cells 1 also becomes small. However, in the cells 1, light having reached the back surface of the semiconductor substrate 2 is transmitted to outside through the passivation films 7. A generated current can be substantially increased by the reflection light 32 by the high-reflectance back sheet 23 just below the back surface of the cells 1 that occupy the most area of the module 40. Because recoupling of carriers can be suppressed by reducing an interface state between the semiconductor substrate 2 and the passivation films 7, a generated voltage is also increased. Accordingly, a high output can be obtained in the module 40.

Further, in the module 40, by forming the back surface electrodes 6 on a part of a surface of the semiconductor substrate 2 without forming the back surface electrodes 6 on the entire surface of the semiconductor substrate 2, occurrence of warpage caused by a difference between a thermal expansion coefficient of the semiconductor substrate 2 and that of the back surface electrodes 6 can be suppressed.

A manufacturing method of the module 40 is explained next. For a manufacturing method of the cells 1, the first embodiment is to be referred to, and a process after manufacturing the cells 1 is explained below. First, the front-surface filling material (sealant) 22a, and a plurality of the cells 1 connected to each other to extract power to outside are superimposed in this order on the module glass 21. Next, a pigment of a dark color is arranged in a region between adjacent cells 1 on the front-surface filling material (sealant) 22a. Further, the back-surface filling material (sealant) 22b and the high-reflectance back sheet 23 are superimposed in this order, and thereafter, these are thermally pressed in vacuum, for example. As a result, portions from the module glass 21 to the high-reflectance back sheet 23 are integrated together by the front-surface filling material (sealant) 22a and the back-surface filling material (sealant) 22b, thereby completing the module 10. The low reflectance portion 41 is formed by a pigment of a dark color between the front-surface filling material (sealant) 22a and the back-surface filling material (sealant) 22b in a region between adjacent cells 1.

As described above, according to the module 40 of the present embodiment, light having transmitted through the cells 1 is reflected by the high-reflectance back sheet 23, and is inputted again into the cells 1, thereby making it possible to increase the output by increasing the current generated by the cells 1. At the same time, light inputted between adjacent cells 1 is reflected by the low reflectance portion 41, thereby making it possible to suppress occurrence of unnecessary light reflection to outside of the module 10. In the module 40, by forming the back surface electrodes 6 on a part of a surface of the semiconductor substrate 2 without forming the back surface electrodes 6 on the entire surface of the semiconductor substrate 2, occurrence of warpage caused by a difference between a thermal expansion coefficient of the semiconductor substrate 2 and that of the back surface electrodes 6 can be suppressed. Therefore, according to the module 40 of the present embodiment, a solar battery module that achieves a high output, thinning, and low light pollution can be obtained.

### Third embodiment.

FIG. 6 is a cross-sectional view of a configuration of a module 50 according to a third embodiment of the present invention. The module 50 according to the present embodiment has a configuration (not shown) that a plurality of the cells 1 are electrically and directly connected to each other in a similar manner to that of the module 10. In FIG. 6, like reference letters or numerals are denoted to like members as those in FIG. 1 and detailed explanations thereof will be omitted.

The module 50 according to the third embodiment is different from the module 10 according to the first embodiment in that a low reflectance sheet 51 having a low reflection rate is arranged between regions corresponding to regions between adjacent cells 1. Further, the module 50 is different from the module 10 in that the back surfaces of the passivation films 7 and a front-surface side surface of the low reflectance sheet 51 are arranged in contact with each other at similar positions in a thickness direction of the module 10, in an external peripheral region of the module 10.

For the low reflectance sheet 51, a sheet that is made of the same material as that of the high-reflectance back sheet 23 and coated in a dark color can be used, for example. Further, a sheet having a dark color by mixing a pigment of a dark color into a sheet made of the same material as that of the filling material (sealant) 22 can be also used. An arrangement position of the low reflectance sheet 51 is not limited thereto, and it suffices that the low reflectance sheet 51 is arranged at any position between the passivation films 7 and a front surface side of the high-reflectance back sheet 23, in a region corresponding to a region between adjacent cells 1 and in an external peripheral region of the module 10.

In the module 50 configured as described above, the incident light 31 of sunlight that is directly inputted to the cells 1 is reflected by the high-reflectance back sheet 23 after having transmitted through the cells 1, and becomes the reflection light 32, and is inputted again into the cells 1. A part of the incident light 31 is reflected by the front surface of the reflection prevention film 4, and becomes the reflection light 33. The reflection light 33 is divided into light (not shown) that is further reflected by the module glass 21 and is inputted again into the cells 1, and light (not shown) that directly exits to outside by passing through the module glass 21. A part of the incident light 31 is reflected by the front surfaces of the passivation films 7 and becomes the reflection light 34, and is inputted again into the cells 1.

Most of the incident light 35 of sunlight that is directly inputted between adjacent cells 1 is absorbed by the low reflectance sheet 51 that is arranged in a region between adjacent cells 1, and the reflection light 36 becomes small. Accordingly, the reflection light 36 that is emitted to outside by passing between the cells 1 becomes small, and unnecessary light pollution to outside can be suppressed.

Meanwhile, light that is reflected by the low reflectance sheet 51 and is further reflected by the module glass 21 and is inputted again into the cells 1 also becomes small. However, in the cells 1, light having reached the back surface of the semiconductor substrate 2 is transmitted to outside through the passivation films 7. A generated current can be substantially increased by the reflection light 32 by the high-reflectance back sheet 23 just below the back surface of the cells 1 that occupy the most area of the module 50. Because recoupling of carriers can be suppressed by reducing an interface state between the semiconductor substrate 2 and the passivation films 7, a generated voltage is also increased. Accordingly, a high output can be obtained in the module 50.

In the module 50, by forming the back surface electrodes 6 on a part of a surface of the semiconductor substrate 2 without forming the back surface electrodes 6 on the entire surface of the semiconductor substrate 2, occurrence of warpage caused by a difference between a thermal expansion coefficient of the semiconductor substrate 2 and that of the back surface electrodes 6 can be suppressed.

A manufacturing method of the module 50 is explained next. For a manufacturing method of the cells 1, the first embodiment is to be referred to, and a process after manufacturing the cells 1 is explained below. First, the front-surface filling material (sealant) 22a, and a plurality of the cells 1 connected to each other to extract power to outside are superimposed in this order on the module glass 21. Next, the low reflectance sheet 51 is arranged between adjacent cells 1 (the passivation films 7). Further, the low reflectance sheet 51 is also arranged to be mounted on the cells 1 (the passivation films 7) in a region that becomes an external peripheral region of the module 10.

Further, the back-surface filling material (sealant) 22b and the high-reflectance back sheet 23 are superimposed in this order, and thereafter, these are thermally pressed in vacuum, for example. As a result, portions from the module glass 21 to the high-reflectance back sheet 23 are integrated together by the front-surface filling material (sealant) 22a and the back-surface filling material (sealant) 22b, thereby completing the module 10.

As described above, according to the module 50 of the present embodiment, light having transmitted through the cells 1 is reflected by the high-reflectance back sheet 23, and is inputted again into the cells 1, thereby making it possible to increase the output by increasing the current generated by the cells 1. At the same time, light that is inputted between adjacent cells 1 is reflected by the low reflectance sheet 51, thereby making it possible to suppress occurrence of unnecessary light reflection to outside of the module 50. In the module 50, by forming the back surface electrodes 6 on a part of a surface of the semiconductor substrate 2 without forming the back surface electrodes 6 on the entire surface of the semiconductor substrate 2, occurrence of warpage caused by a difference between a thermal expansion coefficient of the semiconductor substrate 2 and that of the back surface electrodes 6 can be suppressed. Therefore, according to the module 50 of the present embodiment, a solar battery module that achieves a high output, thinning, and low light pollution can be obtained.

### INDUSTRIAL APPLICABILITY

As described above, the solar battery module according to the present invention is useful for thinning the solar battery substrate.

## Claims

1. A solar battery module having a plurality of solar battery cells embedded in an in-plane direction in a front-surface sealing member by separating the solar battery cells at a distance therebetween, the solar battery cells being electrically connected to each other in a filling material sandwiched between the front-surface sealing member having translucency and a back-surface sealing member, wherein
each of the solar battery cells includes:
a first-conductivity-type semiconductor substrate that has an impurity diffusion layer having a second-conductivity-type impurity element diffused thereon at one surface side;
a reflection prevention film that is formed on the impurity diffusion layer;
a first electrode that is electrically connected to the impurity diffusion layer by penetrating the reflection prevention film;
a passivation film that is formed at another surface side of the semiconductor substrate; and
a second electrode that is embedded in the passivation film and is electrically connected to the another surface side of the semiconductor substrate, and
the back-surface sealing member is a high reflectance portion having a high reflection rate such that an average reflection rate of light of a wavelength in a range of 400 to 1200 nanometers is equal to or higher than 50% in at least a region corresponding to the solar battery cells, and
the back-surface sealing member includes a low reflectance portion having a low reflection rate such that an average reflection rate of light of a wavelength in a range of 400 to 1200 nanometers is lower than 50%, at any position between a front surface of the reflection prevention film of the solar battery cells and the back-surface sealing member, in a region between the solar battery cells adjacent to each other or in a region corresponding to a region in a thickness direction of the solar battery module.

2. The solar battery module according to claim 1, wherein
the back-surface sealing member is a high reflectance sheet having the high reflection rate, and
the low reflectance portion is a coated portion coated with a color having the low reflection rate in a region corresponding to a region between the solar battery cells at a side of the solar battery cell of the high reflectance sheet.

3. The solar battery module according to claim 1, wherein
the back-surface sealing member is a high reflectance sheet having the high reflection rate, and
the low reflectance portion has a low-reflectance material portion having the low reflection rate in a region corresponding to a region between the solar battery cells at a side of the solar battery cell of the high reflectance sheet.

4. The solar battery module according to claim 1, wherein
the back-surface sealing member is a high reflectance sheet having the high reflection rate, and
the low reflectance portion has a low reflectance material having the low reflection rate partially mixed into a region corresponding to a region between the solar battery cells of the high reflectance sheet.

5. The solar battery module according to claim 1, wherein
the back-surface sealing member is a high reflectance sheet having the high reflection rate, and
the low reflectance portion has a low-reflectance material portion having the low reflection rate in a region between the solar battery cells.

6. The solar battery module according to claim 5, wherein the low-reflectance material portion is formed by partially mixing a low reflectance material having the low reflection rate into the filling material.

7. The solar battery module according to claim 1, wherein
the back-surface sealing member is made of a high reflectance sheet having the high reflection rate, and
the low reflectance portion has a low-reflectance material portion having the low reflection rate arranged at any position between the passivation film and the back-surface sealing member in a region corresponding to a region between the solar battery cells.

8. The solar battery module according to claim 7, wherein the low-reflectance material portion is a coated portion that has a color having the low reflection rate coated on a sheet of a same material as that of the high reflectance sheet.

9. The solar battery module according to claim 7, wherein the low-reflectance material portion is formed by mixing a low reflectance material having the low reflection rate into a sheet of a same material as that of the high reflectance sheet.
